# EUROPÄISCHE PATENTSCHRIFT

(11) **EP 1 495 548 B1**
(45) Veröffentlichungstag und Bekanntmachung des Hinweises auf die Patenterteilung: **22.02.2006**
(21) Anmeldenummer: 03747407.9
(22) Anmeldetag: 07.04.2003
(51) Int. Cl.: H03M 13/03, H03M 13/41, G10L 19/00, G06F 17/00, G06T 9/00

(54) **VORRICHTUNG UND VERFAHREN ZUM VERSCHLEIERN EINES FEHLERS**
DEVICE AND METHOD FOR MASKING A FAULT
DISPOSITIF ET PROCEDE DE MASQUAGE D'UNE ERREUR

(30) Priorität: 29.04.2002 DE 10219133
(43) Veröffentlichungstag der Anmeldung: 12.01.2005
(73) Patentinhaber: Fraunhofer-Gesellschaft zur Förderung der angewandten Forschung e.V., 80636 München (DE)
(72) Erfinder: HOMM, Daniel, 91052 Erlangen (DE); SPERSCHNEIDER, Ralph, 91056 Erlangen (DE)
(74) Vertreter: Zimmermann, Tankred Klaus
(86) Internationale Anmeldenummer: PCT/EP2003/003607
(87) Internationale Veröffentlichungsnummer: WO 2003/094358

(56) Entgegenhaltungen:
- EP-A- 0 732 855
- EP-A- 0 966 107
- WO-A-00/68934
- DE-A- 19 840 835
- DE-A- 19 959 038
- US-A- 6 104 754
- ZHANG R ET AL: "VIDEO CODING WITH OPTIMAL INTER/INTRA-MODE SWITCHING FOR PACKET LOSS RESILIENCE" IEEE JOURNAL ON SELECTED AREAS IN COMMUNICATIONS, IEEE INC. NEW YORK, US, Bd. 18, Nr. 6, Juni 2000 (2000-06), Seiten 966-976, XP000954577 ISSN: 0733-8716
- FRAENKEL A S ET AL: "BIDIRECTIONAL HUFFMAN CODING" COMPUTER JOURNAL, OXFORD UNIVERSITY PRESS, SURREY, GB, Bd. 33, Nr. 4, 1. August 1990 (1990-08-01), Seiten 296-307, XP000159500 ISSN: 0010-4620
- TAKISHIMA T ET AL: "REVERSIBLE VARIABLE LENGTH CODES" IEEE TRANSACTIONS ON COMMUNICATIONS, IEEE INC. NEW YORK, US, Bd. 43, Nr. 2/4, PART 1, 1. Februar 1995 (1995-02-01), Seiten 158-162, XP000506544 ISSN: 0090-6778

## Beschreibung

Die vorliegende Erfindung bezieht sich auf die Übertragung von Daten über einen fehlerbehafteten Übertragungskanal und insbesondere auf ein Konzept zum Verschleiern eines Fehlers in einer fehlerhaften oder potentiell fehlerhaften Informationseinheit, die über den fehlerbehafteten Kanal übertragen worden ist.

Insbesondere bei der Audio- und/oder Videocodierung besteht der Bedarf, die Codier/Decodierkonzepte robust gegenüber Übertragungsfehlern zu gestalten. Besonders aus der drahtlosen Übertragungstechnik ist es bekannt, codiererseitig eine Vorwärtsfehlerkorrektur (FEC: FEC = Forward Error Correction) durchzuführen. Durch dieses Konzept wird eine Redundanz in den Datenstrom durch einen Codierer eingeführt. Diese Redundanz kann dann in einem Decodierer beispielsweise unter Verwendung eines Viterbi-Decodierblocks ausgenutzt werden, um bei der Übertragung entstandene Obertragungsfehler zu korrigieren. Nachteilig an diesem Verfahren ist die Tatsache, daß durch die Hinzufügung einer Redundanz im Codierer die Übertragungsrate über den Kanal erhöht wird. Insbesondere bei stark gestörten Übertragungskanälen, wie z.B. drahtlosen Übertragungskanälen, besteht jedoch oftmals keine andere Wahl, um auch bei nicht optimalen Kanalbedingungen einen zuverlässigen Empfang im Empfänger/Decodierer zu ermöglichen.

Auf der anderen Seite besteht insbesondere bei Audio- oder. Videokomprimierverfahren ein Hauptziel darin, Audio- oder Videodäten so stark wie möglich zu komprimieren, um eine Übertragung über typischerweise nicht besonders stark gestörte Kanäle, wie z.B. leitungsgebundene Kanäle, zu ermöglichen, die eine begrenzte Datenrate zulassen. Aus diesem Grund werden bei solchen bekannten Komprimierverfahren, wie sie in der MPEG-Familie standardisiert sind, oftmals Entropie-Codes zumEntropie-Codieren quantisierter Daten, wie z. B. Spektralwerten, eingesetzt. Ein bekannter Vertreter eines Entropie-Codierverfahrens ist die sogenannte Huffman-Codierung, die eine Codierung eines Satzes von Werten mit nahezu minimaler Redundanz ermöglicht. Vor dem Zuweisen der Huffman-Codewörter zu den einzelnen Informationseinheiten wird eine Statistik der Informationseinheiten bestimmt, um dann der am häufigsten auftretenden Informationseinheit ein Codewort mit möglichst kurzer Länge zuzuordnen, während einer Informationseinheit, die sehr selten auftritt, ein Codewort mit großer Länge (bezogen auf die Anzahl von Bits) zugewiesen wird.

Problematisch an Huffman-Codes ist, daß aus einem Datenstrom aus Huffman-Codeworten nicht ersichtlich ist, wo ein Codewort anfängt (abgesehen von dem ersten Codewort), und wo ein Codewort aufhört. Ein Datenstrom aus Huffman-Codeworten besteht typischerweise aus einer Aneinanderreihung von binären Einsen und Nullen. Ein Decodierer decodiert einen solchen Datenstrom aus Huffman-Codeworten unter Kenntnis der beim Codieren zugrundegelegten Codetabelle. Die Codetabelle, die auch als Code-Baum dargestellt werden kann, ist so gestaltet, daß sich das Ende eines Codeworts aufgrund der Präfix-Freiheit des Codes (im Codebaum sind nur Blätter gültige Codewörter) inhärent ergibt. Der Huffman-Code hat die Eigenschaft, daß alle "Zweige" des Baums abgeschlossen sind, also zu gültigen Codewörtern führen.

Tritt während der Übertragung eines solchen Datenstroms aus Huffman-Codewörtern ein Übertragungsfehler auf, so wird dies nahezu unweigerlich dazu führen, daß zwar bis zum Auftreten des Fehlers alle Codewörter korrekt decodiert worden sind, daß jedoch nach dem Auftreten des Fehlers, der beispielsweise nur ein Bit betreffen kann, alle Codewörter fehlerhaft decodiert werden. Wenn ein Code gewählt ist, bei dem alle Zweige mit gültigen Codewörtern abgeschlossen sind, so wird der Decodierer unbeeindruckt von dem Fehler einfach weiterdecodieren und erst am Ende des Datenstroms feststellen, daß irgendwo weiter vorn ein Fehler aufgetreten ist, wenn für das letzte Codewort die Bits im Datenstrom ausgehen oder Bits übrigsind. Der Huffman-Code als Beispiel eines Entropie-Codes ist somit zwar aus Sicht der Datenratenkomprimierung günstig. Die Fehlerrobustheit ist jedoch minimal, da bereits ein Bitfehler im allerersten Codewort sehr wahrscheinlich dazu führt, daß alle anderen nachfolgenden Codewörter, obgleich sie nicht durch Bitfehler betroffen worden sind, vom Decodierer falsch erkannt werden.

Ein fehlerrobusterer Ansatz ist in dem US-Patent Nr. 5,852,469 beschrieben. Statt der Verwendung von Huffman-Codes wird hier vorgeschlagen, umkehrbare (d. h. beidseitig decodierbare) Codes mit Codewörtern variabler Länge (im folgenden als umkehrbare Codewörter bezeichnet), wie z.B. symmetrische Codewörter, zu verwenden. Diese Codes, die neben der Eigenschaft der Präfix-Freiheit auch die Eigenschaft der Suffix-Freiheit haben, werden auch als RVL-Codes bezeichnet (RVL = Reversible Variable Length). Darüber hinaus wird statt des für einen Huffman-Decodierer ausreichenden Vorwärts-Decodierers ein zusätzlicher Rückwärts-Decodierer eingesetzt. Der Vorwärts-Decodierer führt eine Decodierung von einem Startpunkt eines Blocks von umkehrbaren Codewörtern variabler Länge durch, während der Rückwärts-Decodierer ausgehend von einem Endpunkt des Blocks von umkehrbaren Codewörtern variabler Länge vorgeht.

Umkehrbare Codewörter, wie z. B. symmetrische Codewörter, können ferner die Eigenschaft haben, daß sie zu einem Codebaum führen, bei dem nicht alle Zweige durch gültige Codewörter abgeschlossen sind. Ein Decodierer wird daher bereits während des Laufs der Decodierung erkennen, ob ein Fehler aufgetreten ist, wenn der Decodierer auf ein solches ungültiges Codewort, d.h. ein Codewort, das in der Codetabelle nicht vorgesehen ist, stößt. Der Decodierer kann jedoch nicht mit Sicherheit bestimmen, ob der Fehler genau in dem Codewort war, das als ungültig erkannt worden ist. Nachdem die Anzahl der gültigen Codewörter dieser Codetabelle aus Datenkomprimierungsgründen so gering wie möglich gewählt wird, existieren nur einige wenige ungültige Codewörter, so daß ein Decodierer unter Umständen erst einige Codewörter nach Auftreten des Obertragungsfehlers im Bitstrom auf ein ungültiges Codewort stößt. Ein Fehler im Bitstrom führt also zu Fortsetzungsfehlern die jedoch nicht mehr, wie beim Huffman-Code, den gesamten restlichen Bitstrom betreffen, sondern die sich typischerweise nur über einige Codewörter nach Auftreten des Fehlers ausbreiten. Zur Fehlereingrenzung wird neben dem Vorwärts-Decodierer der Rückwärts-Decodierer vorgesehen, der, wenn davon ausgegangen wird, das nur ein einziger Bitfehler im Datenstrom vorhanden ist, in Rückwärtsrichtung ebenfalls aufgrund der Fortsetzungsfehler noch ein paar Codewörter als scheinbar korrekte Codewörter ausgeben wird. Ein Fehler ist zu erkennen, wenn der Vorwärts-Decodierer und der Rückwärts-Decodierer für Informationseinheiten gleicher Ordnungszahl im Block von Informationseinheiten unterschiedliche decodierte Informationseinheiten ausgeben.

Das US-Patent Nr. 5,852,469 schlägt daher vor, in diesem Fehlerbereich sämtliche Ausgaben wegzuwerfen und nur ausgehend von dem Startpunkt des Blocks von Codewörtern bis zum Beginn des Fehler- oder Überlappungsbereichs codierte Informationseinheiten für eine empfängerseitige Weiterverarbeitung zu verwenden, und darüber hinaus nur vom Endpunkt des Blocks von Codewörtern bis zum Ende (in Vorwärtsrichtung betrachtet) des Uberlappungsbereiches decodierte Informationseinheiten zu verwenden.

Die DE 198 40 835 A1 offenbart ebenfalls eine Vorrichtung und ein Verfahren zum Entrppie-Codieren von Informationswörtern und eine Vorrichtung und ein Verfahren zum Decodieren von entropie-codierten Informationswörtern. Für in dem Fehlerüberlappungsbereich decodierte Informationseinheiten wird vorgeschlagen, eine Fehlerverschleierungstechnik einzusetzen. Mögliche Fehlerverschleierungstechniken bestehen in einem einfachen Ersetzen eines fehlerhaften Werts durch seinen benachbarten intakten Wert. Wenn beide intakten Werte, die an einem Fehler angrenzen, bekannt sind, können auch gewichtete Mittelwerte aus linkem und rechtem Rand verwendet werden, um denfehlerhaften Wert künstlich zu ersetzen, d.h. zu verschleiern. Weitere genannte Fehlerverschleierungstechniken verwenden eine Interpolation unter Verwendung zweier benachbarter Werte, zwischen denen ein Fehler liegt. Genauso kann eine einseitige Prädiktion von vorn oder von hinten bezogen auf den Oberlappungsbereich vorgenommen werden, um einen fehlerhaften Wert durch einen "möglicherweise relativ intakten" Wert zu ersetzen.

Nachteilig an diesem Konzept ist die Tatsache, daß es problematisch ist, wenn mehrere aufeinanderfolgende Informationseinheiten durch Fortsetzungsfehler beeinträchtigt worden sind. Interpolations- oder Prädiktions-basierte Verschleierungstechniken werden in diesem Fall sehr schnell an ihre Grenzen stoßen, und die Qualität der Fehlerverschleierung wird immer stärker abnehmen.

Das U.S.-Patent Nr. 6,104,754 offenbart ein Bewegtbild-Codier/Decodier-System unter Verwendung einer Codierung mit Codewörtern variabler Länge. Insbesondere wird mit umkehrbaren Codewörtern variabler Länge gearbeitet, die von vorne und von hinten dekodiert werden können. Stellt ein Vorwärts-Decodierer einen Fehler fest, und stellt ein Rückwärts-Decodierer ebenfalls einen Fehler fest, so wird der Bereich einschließlich der beiden Fehler, wenn er nicht überlappt, verworfen. Überlappt der Bereich dagegen, so wird die Ausgabe des Vorwärts-Decodierers bis zum Fehler ausschließlich des Fehlers genommen. Ab dem Fehler wird dann die Ausgabe des Rückwärts-Decodierers genommen. Alternativ kann auch die Ausgabe des Rückwärts-Decodierers bis zum Fehler genommen werden, und dann die Ausgabe des Vorwärts-Decodierers ab dem Fehler. Wird nur im Vorwärts-Decodierer ein Fehler festgestellt, so wird die Ausgabe des Vorwärts-Decodierers bis zum Fehler genommen, und die Ausgabe des Rückwärts-Decodierers ab dem Fehler genommen. Stellen beide Decodierer einen Fehler im selben Codewort fest, so wird das fehlerhafte Codewort verworfen, wird die Ausgabe des Vorwärts-Decodierers bis zum Fehler genommen, und wird die Ausgabe des Rückwärts-Decodierers bis zum Fehler genommen.

Die DE 19959038 A1 offenbart ein Verfahren zur Decodierung von digitalen Audiodaten, bei dem eine Fehlererkennung in Abhängigkeit von übertragenen Referenzwerten, vorzugsweise Skalenfaktoren, durchgeführt wird. Hierbei werden Referenzwerte eines Frequenzbereichs mit vorhergehenden Referenzwerten des gleichen Frequenzbereichs verglichen, um ein Merkmal zu erzeugen, das mit einem Schwellenwert verglichen wird. Wenn das Merkmal über dem vorgegebenen Schwellenwert liegt, wird dies mittels einer Signalisierung angezeigt. Zur Fehlerverschleierung werden als Fehler markierte Referenzwerte durch vorhergehende Referenzwerte, welche abgespeichert wurden, ersetzt.

Das Dokument EP-A-0 966 107 offenbart eine Vorrichtung zum Verschleiern eines Fehlers in einer fehlerhaften oder potentiell fehlerhaften Informationseinheit mit einer Einrichtung zum Vorwärts-Decodieren eines Blocks von umkehrbaren Codewörtern variabler Länge, die einen Block von Informationseinheiten darstellen, wobei der Block von Codewörtern einen Startpunkt und einen Endpunkt hat, wobei die Einrichtung zum Vorwärts-Decodieren ausgebildet ist, um den Block ausgehend von dem Startpunkt in Richtung des Endpunkts zu decodieren und einer Einrichtung zum Ruckwäns-Decodieren des Blocks von Codewörtern ausgehend von dem Endpunkt in Richtung des Startpunkts, und einer Einrichtung zum Ermitteln eines Fehlerverschleierungsbereichs, wobei der Fehlerverschleierungsbereich dadurch gegeben ist dass die Einrichtung zum Vorwärts-Decodieren einen decodierten Vorwärts-Decodierungswert für die Informationseinheit liefert, und die Einrichtung zum Rückwärts-Decodieren einen decodierten Rückwärts- Decodierungswert für die Informationseinheit liefert, wobei der Vorwärts-Decodierungswert und der Rückwärts-Decodterungswert für ein und dieselbe Informationseinheit voneinander abweichen. In der EP-A-0 966 107 ist eine Einrichtung zum Wegwerfen sowohl der Ausgabe des Vorwärts-Decodierungswerts als auch der Ausgabe des Rückwärts-Decodierungswerts in einem Fehlerverschleierungsbereich beschrieben.

Die Aufgabe der vorliegenden Erfindung besteht darin, ein verbessertes Konzept zum Verschleiern eines Fehlers in einer fehlerhaften oder potentiell fehlerhaften Informationseinheit zu schaffen.

Diese Aufgabe wird durch eine Vorrichtung zum Verschleiern eines Fehlers nach Patentanspruch 1, durch ein Verfahren zum Verschleiern eines Fehlers nach Patentanspruch 24 oder durch ein Computer-Programm nach Patentanspruch 25 gelöst.

Der vorliegenden Erfindung liegt die Erkenntnis zugrunde, daß, wenn aus Anschaulichkeitsgründen nur von einem einzigen Bitfehler ausgegangen wird, einer der beiden unterschiedlichen Werte für die Informationseinheit, die von dem Vorwärts-Decodierer und dem Rückwärts-Decodierer ausgegeben werden, der richtige Wert ist. Durch die klassischen bekannten Fehlerverschleierungstechniken wird jedoch auf diese Eigenschaften keine Rücksicht genommen. Hier wird davon ausgegangen, daß im Falle zweier unterschiedlicher Werte für dieselbe Informationseinheit ein Problem aufgetreten ist, das dadurch zu verschleiern ist, daß gleich beide Werte eliminiert werden. Erfindungsgemäß wird dagegen von dem "Wegwerfen" von korrek-ten Werten abgegangen und statt dessen eine Untersuchung der beiden Werte durchgeführt, um den Wert als verschleierte Informationseinheit auszuwählen, der plausibler erscheint. In anderen Worten umfaßt eine erfindungsgemäße Fehlerverschleierungsvorrichtung eine Einrichtung zum Auswählen des von dem Vorwärts-Decodierer ausgegebenen Werts oder des von dem Rückwärts-Decodierer ausgegebenen Werts als Informationseinheit, abhängig davon, welcher Wert ein vorbestimmtes Kriterium erfüllt, also plausibel ist, so daß ein potentieller Fehler in der Informationseinheit verschleiert ist.

Das erfindungsgemäße Konzept hat den Vorteil, daß tatsächlich durch das Vorwärts-Decodieren einerseits und das Rückwärts-Decodieren andererseits Fortsetzungsfehler bei nur einem fehlerhaften Codewort im Übertragungsstrom komplett eliminiert werden können, wenn die Auswahl aufgrund des vorbestimmten Kriteriums zu einem richtigen Wert führt. Wenn eine Differenzcodierung auf die Informationseinheiten angewendet worden ist, kann sogar noch dieses eine fehlerhafte Codewort aufgrund der Differenzinformationen von Vorwärts bzw. von Rückwärts ebenfalls komplett rekonstruiert werden.

Bemerkenswert hierbei ist, daß die Fehlerverschleierung bei Auftreten eines einzigen Fehlers (eine richtige Auswahl aufgrund des vorbestimmten Kriteriums vorausgesetzt) eine exakte Rekonstruktion ist, die zudem ohne Erhöhung der Datenrate beispielsweise mittels FEC-Techniken etc. erreicht wird, wobei bei zugrundeliegender Differenzcodierung sogar das falsche Codewort ebenfalls korrekt rekonstruiert werden kann. Zur Fehlerverschleierung wird lediglich ein Aufwand im Decodierer betrieben. Dieser Aufwand im Decodierer ist jedoch dann vertretbar, wenn die Übertragungsrate des Übertragungskanals eine entscheidendere Designoption ist als ein aufwandsarmer Decodierer. Ferner sei darauf hingewiesen, dass auch im Falle einer FEC-Codierung im Codierer ein Decodierer eingesetzt werden muß, der aufwendiger ist als ein ganz normaler Codewort-Decodierer.

Die Plausibilitätsprüfung, also die Auswahl eines Werts des Wertepaares der beiden Decodierer wird anhand einer vorbekannten Eigenschaft des durch die Informationseinheiten bestimmten Informationssignals, das beispielsweise ein Audio- und/oder Videosignal sein kann, durchgeführt. Skalenfaktoren eines Audiosignals haben beispielsweise die Eigenschaft, daß sie sich von einem Skalenfaktorband zum nächsten im allgemeinen nicht besonders stark ändern. In diesem Fall besteht das vorbestimmte Kriterium darin, daß der Decodierer-Ausgangswert verwendet wird, der sich von einem letzten intakten oder bereits wieder rekonstruierten Skalenfaktor weniger unterscheidet als der andere Decodierer-Ausgangswert.

Bei einem weiteren Ausführungsbeispiel der vorliegenden Erfindung wird als vorbestimmtes Kriterium verwendet, daß sich die Skalenfaktoren auch von Block zu Block nicht besonders stark ändern, so daß zur Entscheidung, welcher der beiden Decodierer-Ausgangswerte der bessere ist, auf einen entsprechenden Skalenfaktor eines vorausgehenden Blocks zurückgegriffen wird.

Das vorbestimmte Kriterium kann jedoch auch energiemäßig gestaltet werden. In diesem Fall wird davon ausgegangen, daß sich die Energie von einem Skalenfaktorband eines früheren Blocks zu dem selben Skalenfaktorband im späteren Block oder eines Skalenfaktorbands des aktuellen Blocks und des nächsten Skalenfaktorbands des aktuellen Blocks relativ gering ändert. Im Gegensatz zu den vorher beschriebenen Ausführungsbeispielen muß in diesem Fall die Energie der Spektralwerte in den entsprechenden Skalenfaktorbändern bestimmt werden, um die Plausibilitätsüberprüfung durchführen zu können.

Das vorbestimmte Kriterium kann auch dahingehend gewählt werden, daß nicht nur von einem Wertepaar zum nächsten im Überlappungsbereich vorgegangen wird, sondern daß mehrere oder alle Wertepaare im Überlappungsbereich verwendet werden. In diesem Fall können alle möglichen Wege durch alle Wertepaare konstruiert werden, um dann den Weg auszuwählen, der insgesamt dem vorbestimmten Kriterium am nächsten kommt, also der z. B. die geringste Gesamtänderung hat. Die Gesamtänderung ist eine gewichtete oder ungewichtete Summe von Einzeländerungen, also von einem Wertepaar zum nächsten. Alternativ oder zusätzlich kann auch eine Wegauswahl getroffen werden, um beispielsweise die Wege zu verwerfen, bei denen mehr als einmal von z. B. einem Vorwärts-Decodierungswert auf einen Rückwärts-Decodierungswert gewechselt wird.

Allgemein gesagt existieren von vielen Informationssignalen vorbekannte Eigenschaften dahin gehend, daß das Signal beispielsweise monoton steigend sein muß, monoton fallend sein muß, sich von einem Punkt zum nächsten sprunghaft oder allmählich oder um einen bestimmten Betrag etc. ändert oder nicht. Eines dieser Kriterien oder mehrere Kriterien gemeinsam können dazu verwendet werden, aus den beiden durch den Vorwärts-Decodierer und den Rückwärts-Decodierer zur Verfügung gestellten Werten den richtigen bzw. den besseren herauszusuchen.

Wie es bereits ausgeführt worden ist, besteht der Vorteil des erfindungsgemäßen Konzepts darin, daß im Falle nur eines einzigen Bitfehlers prinzipiell eine vollständige Rekonstruktion erreicht werden kann. Jedoch auch bei Auftreten mehrerer Bitfehler kann eine Verschleierung erreicht werden, wenn der Decodierer in Vorwärtsrichtung und in Rückwärtsrichtung eine ausreichende Anzahl von Fortsetzungsfehlern erzeugt, so daß ein Überlappungsbereich, d.h. ein Fehlerverschleierungsbereich, entsteht, in dem für eine Informationseinheit einer bestimmten Ordnungszahl im Block zwei verschiedene "Vorschläge" der beiden Decodierer vorliegen. Eine vollständige. Rekonstruktion ist in diesem Fall allerdings nicht möglich, da zwischen mehreren Bitfehlern befindliche decodierte Werte im allgemeinen nicht korrekt sind.

Bei einem bevorzugten Ausführungsbeispiel der Erfindung hängt das vorbestimmte Kriterium von einer vorbekannten Eigenschaft eines durch Informationseinheiten aus einem aktuellen, vorausgehenden und/oder nachfolgenden Block dargestellten Informationssignal ab, wobei das vorbestimmte Kriterium erfüllt ist, wenn eine Eigenschaft des Informationssignals unter Berücksichtigung des ausgewählten Werts näher an der vorbekannten Eigenschaft liegt als eine Eigenschaft des Informationssignals unter Berücksichtigung eines nicht ausgewählten Werts.

Bevorzugte Ausführungsbeispiele der vorliegenden Erfindung werden nachfolgend Bezug nehmend auf die beiliegenden Zeichnungen detailliert erläutert. Es zeigen:
- Fig. 1: ein Blockschaltbild einer erfindungsgemäßen Vorrichtung zur Fehlerverschleierung;
- Fig. 2: eine Skizze zur Darstellung des Zustandekommens eines Fehlerverschleierungsbereichs durch Fortsetzungsfehler sowohl im Vorwärts-Decodierer als auch im Rückwärts-Decodierer;
- Fig. 3: eine Prinzipskizze zur Darstellung der erfindungsgemäßen Fehlerverschleierung, bei der das vorbestimmte Kriterium auf der Basis einer zuletzt korrekt decodierten Informationseinheit oder einer zuletzt verschleierten und möglicherweise korrekten Informationseinheit durchgeführt wird; und
- Fig. 4: eine Prinzipskizze gemäß einem alternativen Ausführungsbeispiel der vorliegenden Erfindung, bei dem ein zeitlich vorausgehender Block von decodierten Informationseinheiten eine Grundlage für das vorbestimmte Kriterium liefert.

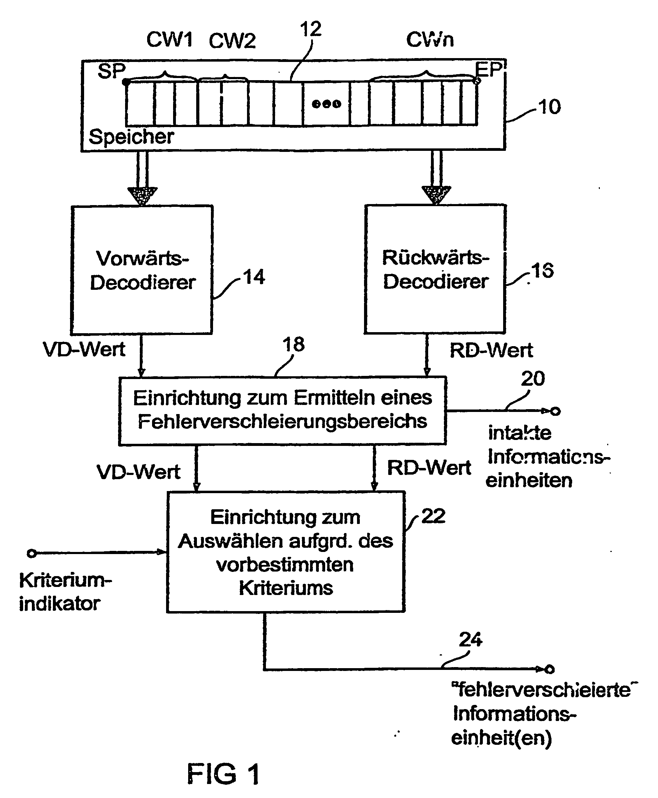

Fig. 1 zeigt ein bevorzugtes Ausführungsbeispiel einer erfindungsgemäßen Vorrichtung zum Fehlerverschleiern. Der Vorrichtung zugeordnet ist ein Speicher 10, in dem eine Folge von Bits 12 gespeichert ist, die einen Block von umkehrbaren Codewörtern variabler Länge darstellen. Das erste Codewort CW1 könnte beispielsweise drei Bits umfassen, während das zweite Codewort lediglich zwei Bits umfaßt und das letzte Codewort CWn beispielsweise fünf Bits umfaßt.

Der Bitstrom 12 präsentiert sich sowohl einem Vorwärts-Decodierer 14 als auch einem Rückwärts-Decodierer lediglich als Folge von Bits, da der Beginn und das Ende eines Codeworts, wie es ausgeführt worden ist, inhärent und nicht explizit enthalten sind. Der Vorwärts-Decodierer ist ausgebildet, um eine Decodierung des Bitstroms 12 ausgehend von einem Startpunkt SP, der in Fig. 1 am linken Ende des Stroms beispielhaft eingezeichnet ist, zu beginnen, während der Rückwärts-Decodierer 16 ausgebildet ist, um eine Decodierung des Bitstroms 12 von einem Endpunkt EP, der in Fig. 1 am rechten Ende des Bitstroms 12 eingezeichnet ist, zu beginnen.

Sowohl der Vorwärts-Decodierer 14 als auch der Rückwärts-Decodierer 16 speisen eine Einrichtung 18 zum Ermitteln eines Fehlerverschleierungsbereichs. Insbesondere liefert der Vorwärts-Decodierer einen Vorwärts-Decodierungswert für das erste Codewort CW1, dann einen nächsten Vorwärts-Decodierungswert für das Codewort CW2 etc. Analog hierzu liefert der Rückwärts-Decodierer einen Rückwärts-Decodierungswert zunächst für das Codewort CWn und dann für das Codewort CW(n-1), etc.

Ein Fehlerversohleierungsbereich ist dann gegeben, wenn der Vorwärts-Decodierer 14 und der Rückwärts-Decodierer 16 unterschiedliche Ausgangswerte für ein und dasselbe Codewort liefern. Anders ausgedrückt, liegt der Fehlerverschleierungsbereich dann vor, wenn zwei unterschiedliche "Vorschläge" für ein und dieselbe Informationseinheit der Einrichtung zum Ermitteln eines Fehlerverschleierungsbereichs zugeführt werden.

In diesem Fall wird eine Einrichtung 22 zum Auswählen entweder der Ausgabe des Vorwärts-Decodierers 14, also des Vorwärts-Decodierungswerts, oder der Ausgabe des Rückwärts-Decodierers 16, also des Rückwärts-Decodierungswerts, für ein Codewort aktiv.

Alternativ wird der Überlappungsbereich dadurch erzeugt, daß zunächst nur ein Decodierer, z. B. der Vorwärts-Decodierer, arbeitet. Erst wenn er auf einen Fehler stößt und das Decodieren abbricht, wird der andere Decodierer, im Beispiel der Rückwärts-Decodierer, aktiviert, so daß, wenn auch der Rückwärts-Decodierer aufgrund des Fehlers seine Arbeit abbricht, ein überlappungsbereich entstanden sein kann.

Die Einrichtung 22 zum Auswählen ist ausgebildet, um den Wert der beiden Alternativen auszuwählen, der ein vorbestimmtes Kriterium erfüllt, was dazu führt, daß ein Fehler oder ein potentieller Fehler in der Informationseinheit bzw. entsprechend in dem Codewort verschleiert ist. Die Einrichtung 22 liefert an ihrem Ausgang 24 somit fehlerverschleierte Informationseinheiten, wobei jedoch darauf hingewiesen wird, daß diese Informationen ideal fehlerverschleiert sind, also komplett rekonstruiert worden sind, wenn nur ein einziges fehlerhaftes Codewort in dem Bitstrom 12 vorhanden gewesen ist und die Auswahl aufgrund des vorbestimmten Kriteriums richtige Werte geliefert hat.

Wie später ausgeführt wird, existiert bei einem bevorzugten Ausführungsbeispiel ein Kriteriumindikator, der der Einrichtung 22 zugeführt wird, um abhängig von einer durch den Indikator angezeigten Eigenschaft des Informationssignals, das durch die Informationseinheiten bestimmt wird, von einem vorbestimmten Kriterium zu einem anderen vorbestimmten Kriterium umzuschalten. Generell wird das vorbestimmte Kriterium von der vorbekannten Eigenschaft eines durch die Informationseinheiten bestimmten Informationssignals abhängen, wobei das Informationssignal ein Audiosignal und/oder ein Videosignal sein kann.

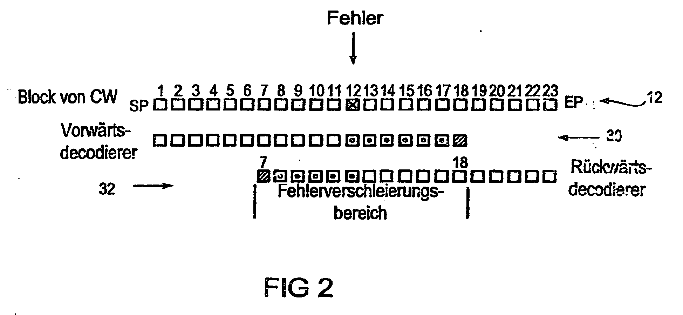

Fig. 2 ist eine detailliertere Darstellung der Ausgangssituation, an der die erfindungsgemäße Fehlerverschleierungstechnik zum Tragen kommt. In einer ersten Zeile von Fig. 2 ist der Block von umkehrbaren Codewörtern variabler Länge 12 mit einem Startpunkt SP und einem Endpunkt EP gezeigt, wobei zusätzlich, über den durch kleine Quadrate symbolisierten Codewörtern variabler Länge Ordnungszahlen für die Codewörter variabler Länge eingetragen sind. Bei dem in Fig. 2 gezeigten Beispiel umfaßt der Block von Codewörtern variabler Länge insgesamt 23 Codewörter. Die Darstellung in Fig. 2 ist lediglich schematisch, da die Länge in Bits der einzelnen Codewörter variabler Länge selbstverständlich nicht für jedes Codewort gleich ist, sondern von Codewort zu Codewort unterschiedlich ist. Ferner sei angenommen, daß in dem Codewort mit der Ordnungszahl 12 bei der Übertragung des Bitstroms 12 über einen fehlerbehafteten Kanal ein Fehler aufgetreten ist, wie es durch ein Kreuz in Fig. 2 symbolisiert ist.

Der Vorwärts-Decodierer wird ausgehend von dem Startpunkt SP Vorwärts-Decodierungswerte ausgeben, die bis zur Ordnungszahl Nr. 11 korrekte Informationseinheiten sind und erst ab der Ordnungszahl Nr. 12 fehlerhaft sind, wie es durch kleine Punkte in den entsprechenden Quadraten von Fig. 2 symbolisiert ist. Erst bei der Ordnungszahl 18 wird der Vorwärts-Decodierer auf ein ungültiges, wie z.B. nicht-symmetrisches Codewort stoßen, das durch den Bitfehler 12 bewirkt worden ist, das jedoch aufgrund der Fehlerfortpflanzung erst für das Codewort mit der Ordnungs.zahl Nr. 18 zu einem ungültigen Codewort geführt hat. Der Vorwärts-Decodierer wird daher bei dem Codewort Nr. 18 seine Ausgabe beenden.

Analog arbeitet der Rückwärts-Decodierer, er beginnt beim Endpunkt EP des Blocks 12 und wird bis zum Codewort mit der Ordnungszahl Nr. 13 korrekte Ergebnisse liefern und erst dann fehlerhafte Ergebnisse liefern. Ferner wird angenommen, daß der Rückwärts-Decodierer erst bei dem Codewort mit der Ordnungszahl Nr. 7 auf ein ungültiges Codewort stößt und erkennt, daß irgendwo weiter vorn ein Fehler aufgetreten ist.

Selbstverständlich ist dem Decodierer nicht bekannt, daß der Fehler im Codewort Nr. 12 aufgetreten ist. Er muß daher davon ausgehen, daß im Extremfall keine Fehlerfortpflanzung aufgetreten ist. Dies bedeutet in anderen Worten, daß der Fehler in dem Codewort Nr. 12 auch im Codewort Nr. 7 einerseits oder im Codewort Nr. 18 andererseits gelegen haben könnte. Der gesamte Bereich vom Codewort mit der Ordnungszahl Nr. 7 bis zum Codewort mit der Ordnungszahl Nr. 18, der den Fehlerverschleierungsbereich darstellt, ist daher zweideutig.

Dies ist für die Einrichtung 22 zum Auswählen dadurch erkennbar, daß sich der Vorwärts-Decodierungswert von dem Rückwärts-Decodierungswert für ein Codewort derselben Ordnungszahl unterscheidet. Dennoch wird aus der Skizze in Fig. 2 deutlich, daß der Vorwärts-Decodierer vom Codewort Nr. 7 bis zum Codewort Nr. 11 korrekt gearbeitet hat, und daß der Rückwärts-Decodierer ebenfalls vom Codewort Nr. 18 bis zum Codewort Nr. 13 korrekt gearbeitet hat. Diese Erkenntnis wird erfindungsgemä8 dazu genutzt, nunmehr nicht den gesamten Fehlerverschleierungsbereich wegzuwerfen, zu interpolieren oder sonstwie zu ersetzen, sondern die einzelnen Wertepaare für die Ordnungszahlen 7 bis 18 zu untersuchen, um jeweils den Wert auszuwählen, der das vorbestimmte Kriterium erfüllt.

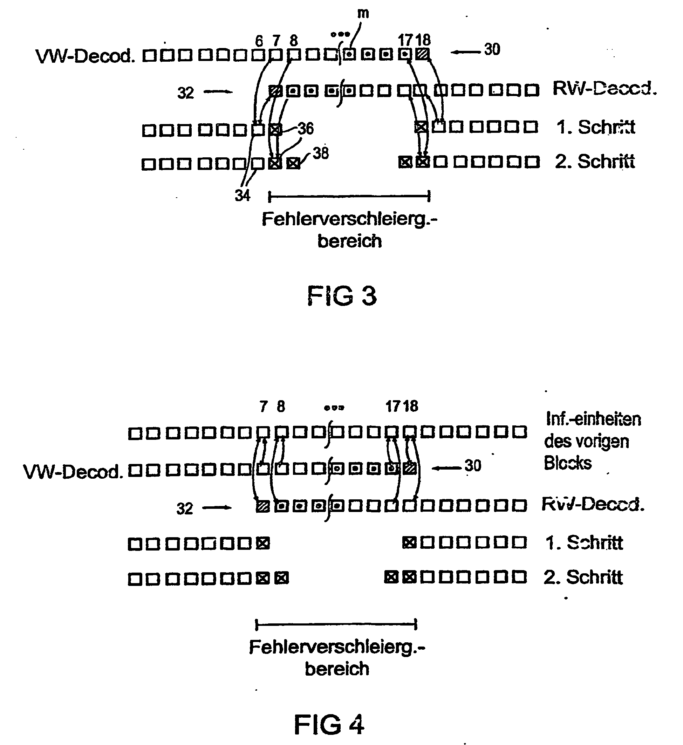

Die nachfolgend erläuterten Figuren 3 und 4 zeigen zwei verschiedene vorbestimmte Kriterien, die z.B. abhängig von dem Kriteriumindikator von Fig. 1 eingesetzt werden können, um eine Fehlerverschleierung zu erreichen. Bei einem bevorzugtem Ausführungsbeispiel der vorliegenden Erfindung sind die durch die Codewörter variabler Länge codierten Informationseinheiten Skalenfaktoren eines gemäß einem MPEG- standard-codierten Audiosignals. Eine vorbestimmte Eigenschaft von Audiosignalen ist, daß sich Skalenfaktoren im allgemeinen von einem Skalenfaktorband zum nächsten, also von einem Skalenfaktor zum frequenzmäßig benachbarten nächsten Skalenfaktor nicht besonders stark ändern. In anderen Worten ausgedrückt bedeutet dies, daß kleine Änderungen zwischen aufeinanderfolgenden Skalenfaktoren eine größere Wahrscheinlichkeit haben als größere Änderungen.

Das vorbestimmte Kriterium bei dem in Fig. 3 gezeigten Beispiel besteht somit darin, daß sowohl der Vorwärts-Decodierungswert für das Codewort mit der Ordnungszahl Nr. 7 bzw. für die Informationseinheit mit der Ordnungszahl Nr. 7 und der Rückwärts-Decodierungswert für das Codewort bzw. die Informationseinheit mit der Ordnungszahl Nr. 7 mit einem Schwellenwert als Referenz verglichen werden, wobei als Schwellenwert der letzte intakte Skalenfaktor, der in Fig. 3 mit 34 bezeichnet ist, verwendet wird. Der Wert also, der näher an dem Skalenfaktor 34 für die Ordnungszahl Nr. 6 liegt, wird als "fehlerverschleierter" Skalenfaktor 36 verwendet.

Nach diesem Vergleich ist ein erster Schritt beendet, und es wird ein zweiter Schritt begonnen, um auch für das Codewort mit der Ordnungszahl Nr. 8 eine Fehlerverschleierung durchzuführen. Hierzu werden die beiden Vorschläge des Vorwärts-Decodierers und des Rückwärts-Decodierers für das Codewort Nr. 8 genommen und mit dem gerade rekonstruierten Skalenfaktor 36 verglichen, um einen weiteren fehlerverschleierten, d.h. rekonstruierten, Skalenfaktor 38 zu erzeugen. Dasselbe wird analog von der anderen Seite des Fehlerverschleierungsbereichs aus durchgeführt, bis von beiden Seiten auf einen mittleren Skalenfaktor m gestoßen wird, wenn dieser existiert.

Manchmal wird der aus der linksseitigen Annäherung erzeugte fehlerverschleierte Wert sich von dem von der rechten Annäherung aus erzeugten fehlerverschleierten Wert unterscheiden. Es könnte einer der beiden Werte zufällig ausgewählt werden. Alternativ wird es jedoch in diesem Fall bevorzugt, einen Mittelwert aus diesen beiden Werten bzw. irgendeinen Wert zu nehmen, der zwischen diesen beiden Werten liegt. Dieser Wert für die mittlere Ordnungszahl m wird mit sehr hoher Wahrscheinlichkeit ein falscher Wert sein, der jedoch zu keiner größeren Abweichung führen wird, da er ja auf der Basis rekonstruierter Werte links und rechts der Ordnungszahl m gebildet worden ist.

Wie es ausgeführt worden ist, kann das vorbestimmte Kriterium auf der Basis des vorherigen oder nachfolgenden Skalenfaktors in frequenzmäßiger Richtung durchgeführt werden. Eine alternative Möglichkeit ist in Fig. 4 dargestellt. In Fig. 4 wird das vorbestimmte Kriterium nicht auf der Basis des frequenzmäßig benachbarten Skalenfaktors aus dem aktuellen Block bestimmt, sondern auf der Basis des Skalenfaktors mit gleicher Ordnungszahl aus dem vorherigen Block. Wieder werden die beiden Vorschläge des Vorwärts-Decodierers und des Rückwärts-Decodierers mit dem Skalenfaktor gleicher Ordnungszahl des vorherigen Blocks verglichen, um dann den Vorschlag zu nehmen, der sich weniger von dem Skalenfaktor des vorherigen Blocks unterscheidet, da, wie es angezeigt worden ist, für Skalenfaktoren in sehr vielen Fällen gilt, daß sie sich von Block zu Block auch nur begrenzt ändern.

Eine Auswahl zwischen dem in Fig. 3 gezeigten vorbestimmten Kriterium und dem in Fig. 4 gezeigten vorbestimmten Kriterium kann auf der Basis des Kriteriumindikators durchgeführt werden. Der Kriteriumindikator kann beispielsweise dem von dem Codierer erzeugten Bitstrom als Seiteninformation mitgegeben werden, um z.B. für jeden Block anzuzeigen, ob sich die Skalenfaktoren skalenfaktorbandmäßig in diesem Block oder bezüglich eines zeitlich benachbarten Blocks stark ändern oder nicht. Ändern sich die Skalenfaktoren in einem aktuellen Block sehr stark, so wird das in Fig. 3 gezeigte vorbestimmte Kriterium nicht so gut arbeiten. In diesem Fall wird das in Fig. 4 gezeigte Kriterium möglicherweise besser funktionieren, so daß für einen solchen Block der Kriteriumindikator so beschaffen sein wird, daß die Einrichtung 22 derart initialisiert wird, daß sie das in Fig. 4 gezeigte Fehlerverschleierungskriterium anwendet, das auf dem vorherigen Block und nicht auf frequenzmäßig benachbarten Skalenfaktoren, wie in Fig. 3 aufbaut.

Bei einem alternativen Ausführungsbeispiel wird das vorbestimmte Kriterium von den Skalenfaktoren dahin gehend gelöst, daß nicht mehr die Skalenfaktoren alleine als Schwellenwert für das vorbestimmte Kriterium betrachtet werden, sondern daß Energien in Skalenfaktorbändern betrachtet werden. Die Einrichtung 22 zum Auswählen ist daher ausgebildet, um die Energie entweder benachbarter oder zeitlich aufeinanderfolgender Skalenfaktorbänder unter Verwendung der ebenfalls decodierten Spektralwerte zu ermitteln, um dann den Skalenfaktor-Vorschlag zu nehmen, bei dem sich die geringere Energieänderung ergibt.

Bei alternativen Ausführungsbeispielen wird das vorbestimmte Kriterium nicht nur für ein Paar von Werten im Fehlerverschleierungsbereich, sondern für mehrere Paare gemeinsam bestimmt. Hierbei ist die Einrichtung zum Auswählen ausgebildet, um für eine Mehrzahl von verschiedenen Pfaden in dem Fehlerverschleierungsbereich eine Gesamteigenschaft zu ermitteln. Jeder Pfad verläuft zwischen unterschiedlichen Vorwärts- und Rückwärts-Decodierungswerten in unterschiedlichen "Zick-Zack-Wegen". Die Einrichtung zum Auswählen ist hierbei ausgebildet, um die Decodierungswerte auszuwählen, die auf dem Pfad liegen, der eine Gesamteigenschaft hat, die dem vorbestimmten Kriterium entspricht. Die Gesamteigenschaft ist hierbei eine gewichtete oder ungewichtete Summe von Einzeleigenschaften des Pfads.

Alternativ oder zusätzlich wird nur ein Pfad berücksichtigt, der genau einen Wechsel von einem Vorwärts-Decodierungswert zu einem Rückwärts-Decodierungswert oder umgekehrt aufweist. Dieses Ausführungsbeispiel trägt der Situation Rechnung, daß bei Vorliegen eines einzigen Fehlers nur ein einziger Wechsel auftreten kann.

Falls nicht auf Pfaden basierend gearbeitet wird, sondern von Wertepaar zu Wertepaar, kann die vorstehende Erkenntnis dazu ausgenutzt werden, um bei Vorliegen eines Wechsels keinen zweiten Wechsel mehr durchzuführen, sondern ohne Rücksicht auf das vorbestimmte Kriterium solche Decodierungswerte auszuwählen, die keinen weiteren Wechsel erfordern.

Es sei darauf hingewiesen, daß das vorbestimmte Kriterium auf der Basis einer beliebigen bei modernen Codierverfahren ohnehin im Datenstrom enthaltenen Information basieren kann, die eine Aussage über eine Eigenschaft der zu rekonstruierenden Größe zulassen. Solche Informationen sind am Beispiel von Audiosignalen L/R- bzw. M/S-Stereoinformationen, die ebenfalls ein Indikator dafür sind, ob sich die. Informationen- in den beiden Stereokanälen stark unterscheiden oder ähnlich sind und somit ebenfalls ein grobes Maß für die Signalstatistik wiedergeben und damit eine vorbekannte Eigenschaft des Informationssignals definieren.

Abhängig von den Gegebenheiten kann das erfindungsgemäße Fehlerverschleierungsverfahren in Hardware oder in Software implementiert werden. Die Implementierung kann auf einem digitalen Speichermedium, insbesondere einer Diskette oder CD mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computer-Programm-Produkt mit auf einem maschinenlesbaren Träger gespeicherten Programmcode zur Durchführung des erfindungsgemäßen Verfahrens, wenn das Computer-Programm-Produkt auf einem Rechner abläuft. In anderen Worten ausgedrückt kann die Erfindung somit als ein Computer-Programm mit einem Programmcode zur Durchführung des Verfahrens realisiert werden, wenn das Computer-Programm auf einem Computer abläuft.

## Patentansprüche

1. Vorrichtung zum Verschleiern eines Fehlers in einer fehlerhaften oder potentiell fehlerhaften Informationseinheit, mit folgenden Merkmalen:
einer Einrichtung (14) zum Vorwärts-Decodieren eines Blocks (12) von umkehrbaren Codewörtern variabler Länge, die einen Block von Informationseinheiten darstellen, wobei der Block von Codewörtern einen Startpunkt (SP) und einen Endpunkt (EP) hat, wobei die Einrichtung zum Vorwärts-Decodieren (14) ausgebildet ist, um den Block ausgehend von dem Startpunkt in Richtung des Endpunkts zu decodieren;
einer Einrichtung (16) zum Rückwärts-Decodieren des Blocks von Codewörtern ausgehend von dem Endpunkt in Richtung des Startpunkts;
einer Einrichtung (18) zum Ermitteln eines Fehlerverschleierungsbereichs, wobei der Fehlerverschleierungsbereich **dadurch** gegeben ist, daß die Einrichtung zum Vorwärts-Decodieren (14) einen decodierten Vorwärts-Decodierungswert für die Informationseinheit liefert, und die Einrichtung (16) zum Rückwärts-Decodieren einen decodierten Rückwärts-Decodierungswert für die Informationseinheit liefert, wobei der Vorwärts-Decodierungswert und der Rückwärts-Decodierungswert für ein und dieselbe Informationseinheit voneinander abweichen; und
einer Einrichtung (22) zum Auswählen des Vorwärts-Decodierungswerts oder des Rückwärts-Decodierungswerts als Informationseinheit, abhängig davon, welcher Wert ein vorbestimmtes Kriterium erfüllt, so daß ein Fehler oder ein potentieller Fehler in der Informationseinheit verschleiert ist.

2. Vorrichtung, nach Anspruch 1,
bei der die Einrichtung (22) zum Auswählen ausgebildet ist, um einen Schwellenwert zu verwenden, auf dessen Basis das vorbestimmte Kriterium eingestellt ist.

3. Vorrichtung nach Anspruch 2,
bei der die Einrichtung (22) zum Auswählen ausgebildet ist, um als Schwellenwert eine der Informationseinheit benachbarte intakte Informationseinheit oder in einem vorhergehenden Schritt rekonstruierte Informationseinheit zu verwenden, und
wobei das vorbestimmte Kriterium eingestellt ist, daß der Wert als Informationseinheit ausgewählt wird, der näher an dem Schwellenwert liegt oder alternativ von dem Schwellenwert weiter entfernt liegt.

4. Vorrichtung nach einem der Ansprüche 1 - 3,
bei der der Fehlerverschleierungsbereich eine Mehrzahl von Vorwärts-Decodierungswerten und Rückwärts-Decodierungswerten aufweist.

5. Vorrichtung nach einem der Ansprüche 1 - 4,
bei der die Einrichtung (22) zum Auswählen ausgebildet ist, um sowohl für ein Paar aus einem Vorwärts-Decodierungswert und einem Rückwärts-Decodierungswert mit einer niedrigeren Ordnungszahl in dem Fehlerverschleierungsbereich als auch für ein Paar aus einem Vorwärts-Decodierungswert und einem Rückwärts-Decodierungswert mit einer höheren Ordnungszahl in dem Fehlerverschleierungsbereich einen Wert als Informationseinheit auszuwählen.

6. Vorrichtung nach Anspruch 5,
bei der die Einrichtung (22) zum Auswählen ausgebildet ist, um für eine Auswahl aus dem Paar mit der niedrigeren Ordnungszahl einen Schwellenwert auf der Basis der Informationseinheit mit einer um 1 niedrigeren Ordnungszahl zu verwenden, und
um für eine Auswahl aus dem Paar mit der höheren Ordnungszahl einen Schwellenwert auf der Basis der Informationseinheit mit einer um 1 höheren Ordnungszahl zu verwenden.

7. Vorrichtung nach Anspruch 5 oder 6,
bei der die Einrichtung (22) zum Auswählen ausgebildet ist, um schrittweise von der niedrigeren Ordnungszahl zu einer höheren Ordnungszahl und von der höheren Ordnungszahl zu einer niedrigeren Ordnungszahl Informationseinheiten auszuwählen.

8. Vorrichtung nach einem der Ansprüche 5 - 7,
bei der die Einrichtung (22) zum Auswählen ausgebildet ist, um in dem Fall, bei dem die aus zwei Paaren ausgewählten .Informationseinheiten die selbe Ordnungszahl haben und zueinander unterschiedlich sind, eine dritte Informationseinheit zu ermitteln, die einen Wert hat, der zwischen den ausgewählten Informationseinheiten liegt.

9. Vorrichtung nach Anspruch 8,
bei der die dritte Informationseinheit einen Mittelwert aus den ausgewählten beiden Informationseinheiten ist.

10. Vorrichtung nach Anspruch 1 oder 2,
bei der zumindest ein vorausgehender Block oder nachfolgender Block von decodierten Informationseinheiten vorliegt, und
bei der das vorbestimmte Kriterium von dem vorausgehenden oder nachfolgenden Block abhängt.

11. Vorrichtung nach Anspruch 10,
bei der die Einrichtung (22) zum Auswählen ausgebildet ist, um einen Schwellenwert zu verwenden, auf dessen Basis das vorbestimmte Kriterium eingestellt ist, wobei als Schwellenwert eine Informationseinheit des vorausgehenden Blocks oder nachfolgenden Blocks mit einer Ordnungszahl verwendet wird, die in der Nähe der Ordnungszahl oder vorzugsweise gleich der Ordnungszahl der auszuwählenden Informationseinheit ist.

12. Vorrichtung nach einem der vorhergehenden Ansprüche,
bei der das vorbestimmte Kriterium dahin gehend definiert ist, daß eine Änderung von einer Informationseinheit zu einer in dem Block benachbarten Informationseinheit oder zu einer Informationseinheit eines vorausgehenden oder nachfolgenden Blocks von Informationseinheiten der selben Ordnungszahl gering ist.

13. Vorrichtung nach einem der Ansprüche 1 - 12,
bei der die Informationseinheit alleine oder in Zusammenhang mit einer weiteren Größe eine Eigenschaft repräsentiert und das vorbestimmte Kriterium derart definiert ist, daß eine Eigenschaftsänderung klein ist.

14. Vorrichtung nach Anspruch 13,
bei der die Eigenschaft eine Energie ist.

15. Vorrichtung nach Anspruch 14,
bei der die Energieänderung im Hinblick auf eine Änderung zwischen zwei benachbarten Informationseinheiten des selben Blocks oder zwei Informationseinheiten der selben Ordnungszahl in zwei aufeinanderfolgenden Blökken definiert ist.

16. Vorrichtung nach einem der Ansprüche 1 - 15,
bei der die Informationseinheiten Skalenfaktoren eines Audiosignals sind, wobei die Skalenfaktoren zusätzlich zu einer Codierung unter Verwendung von Codewörtern variabler Länge differenz-codiert sind, so daß ein. Codewort variabler Länge einen differenz-codierten Skalenfaktor darstellt.

17. Vorrichtung nach Anspruch 16,
bei der das vorbestimmte Kriterium derart definiert ist, daß eine Energieänderung zu einem frequenzmäßig benachbarten Skalenfaktorband oder einem Skalenfaktorband mit gleicher Ordnungszahl aus einem zeitlich vorausgehenden oder zeitlich nachfolgenden Block klein ist.

18. Vorrichtung nach einem der vorhergehenden Ansprüche,
bei der dem Block von umkehrbaren Codewörtern variabler Länge ein Kriteriumindikator zugeordnet ist, wobei die Einrichtung (22) zum Auswählen ausgebildet ist, um abhängig von dem Kriteriumindikator von einem ersten zu einem zweiten vorbestimmten Kriterium umzuschalten.

19. Vorrichtung nach einem der vorhergehenden Ansprüche,
bei der das vorbestimmte Kriterium von einer vorbekannten Eigenschaft eines durch die Informationseinheiten Leerzeile Informationssignals abhängt.

20. Vorrichtung nach Anspruch 19, bei der das Informationssignal ein Audiosignal und/oder ein Videosignal ist.

21. Vorrichtung nach Anspruch 1 oder 2,
bei der die Einrichtung zum Auswählen ausgebildet ist, um für eine Mehrzahl von verschiedenen Pfaden in dem Fehlerverschleierungsbereich eine Gesamteigenschaft zu ermitteln, wobei sich jeder Pfad zwischen unterschiedlichen Vorwärts- und Rückwärts-Decodierungswerten erstreckt, und wobei die Einrichtung zum Auswählen ausgebildet ist, um die Decodierungswerte auszuwählen, die auf dem Pfad liegen, der eine Gesamteigenschaft hat, die dem vorbestimmten Kriterium entspricht.

22. Vorrichtung nach Anspruch 21, bei der von der Einrichtung zum Auswählen nur ein Pfad berücksichtigt wird, der genau einen Wechsel von einem Verwärts-Decodierungswert zu einem Rückwärts-Decodierungswert oder umgekehrt aufweist.

23. Vorrichtung nach einem der Ansprüche 1 bis 20,
bei der die Einrichtung zum Auswählen ausgebildet ist, um zu erfassen, ob in einem Fehlerverschleierungsbereich mit mehreren Paaren von Vorwärts-Decodierungswerten und Rückwärts-Decodierungswerten bereits ein Wechsel bei einer Auswahl aufgetreten ist, und
bei der die Einrichtung zum Auswählen ausgebildet ist, um im Falle eines Wechsels für dem Wechsel nachfolgende Informationseinheiten ohne Rücksicht auf das vorbestimmte Kriterium solche Decodierungswerte auszuwählen, die keinen weiteren Wechsel erfordern.

24. Verfahren zum Verschleiern eines Fehlers in einer fehlerhaften oder potentiell fehlerhaften Informationseinheit, mit folgenden Schritten:
Vorwärts-Decodieren (14) eines Blocks (12) von umkehrbaren Codewörtern variabler Länge, die einen Block von Informationseinheiten darstellen, wobei der Block von Codewörtern einen Startpunkt (SP) und einen Endpunkt (EP) hat, wobei die Einrichtung zum Vorwärts-Decodieren (14) ausgebildet ist, um den Block ausgehend von dem Startpunkt in Richtung des Endpunkts zu decodieren;
Rückwärts-Decodieren (16) des Blocks von Codewörtern ausgehend von dem Endpunkt in Richtung des Startpunkts;
Ermitteln (18) eines Fehlerverschleierungsbereichs, wobei der Fehlerverschleierungsbereich **dadurch** gegeben ist, daß die Einrichtung zum Vorwärts-Decodieren (14) einen decodierten Vorwärts-Decodierungswert für die Informationseinheit liefert, und die Einrichtung (16) zum Rückwärts-Decodieren einen decodierten Ruckwärts-Decodierungswert für die Informationseinheit liefert, wobei der Vorwärts-Decodierungswert und der Rückwärts-Decodierungswert für ein und dieselbe Informationseinheit voneinander abweichen; und
Auswählen (22) des Vorwärts-Decodierungswerts oder des Rückwärts-Decodierungswerts als Informationseinheit abhängig davon, welcher Wert ein vorbestimmtes Kriterium erfüllt, so daß ein Fehler oder ein potentieller Fehler in der Informationseinheit verschleiert ist.

25. Computer-Programm mit einem Programmcode zur Durchführung des Verfahrens zum Verschleiern eines Fehlers in einer fehlerhaften oder potentiell fehlerhaften Informationseinheit nach Anspruch 24, wenn das Computer-Programm auf einem Computer abläuft.

## Claims

1. A device for concealing an error in an erroneous or potentially erroneous information unit, the device comprising:
a means (14) for forward-decoding a block (12) of reversible code words of variable lengths which represent a block of information units, the block of code words having a starting point (SP) and an end point (EP), the means for forward-decoding (14) being configured to decode the block in the direction of the end point, starting from the starting point;
a means (16) for backward-decoding the block of code words, starting from the end point, in the direction of the starting point;
a means (18) for determining an error-concealment area, the error-concealment area being given by the means for forward-decoding (14) providing a decoded forward-decoding value for the information unit, and the means (16) for backward-decoding providing a decoded backward-decoding value for the information unit, the forward-decoding value and the backward-decoding value deviating from one another for one and the same information unit; and
a means (22) for selecting the forward-decoding value or the backward-decoding value as an information unit, depending on which value meets a predetermined criterion, so that an error or a potential error in the information unit is concealed.

2. Device as claimed in claim 1,
wherein the means (22) for selecting is configured to use a threshold value, on the basis of which the predetermined criterion is set.

3. The device as claimed in claim 2,
wherein the means (22) for selecting is configured to use, as a threshold value, an intact information unit adjacent to the information unit, or an information unit reconstructed in a preceding step, and
the predetermined criterion being set such that that value which is closer to the threshold value or, alternatively, is further away from the threshold value is selected as an information unit.

4. The device as claimed in any of claims 1 to 3,
wherein the error-concealment area comprises a plurality of forward-decoding values and backward-decoding values.

5. The device as claimed in any of claims 1 to 4,
wherein the means (22) for selecting is configured to select a value as an information unit both for a pair of a forward-decoding value and a backward-decoding value having a lower ordinal number in the error-concealment area and for a pair of a forward-decoding value and a backward-decoding value having a higher ordinal number in the error-concealment area.

6. The device as claimed in claim 5,
wherein the means (22) for selecting is configured to use a threshold value on the basis of the information unit with an ordinal number lower by 1 for a selection from the pair with the lower ordinal number, and
to use a threshold value on the basis of the information unit with an ordinal number higher by 1 for a selection from the pair with the higher ordinal number.

7. The device as claimed in claim 5 or 6,
wherein the means (22) for selecting is configured to select information units in a step-by-step manner from the smaller ordinal number to a higher ordinal number and from the higher ordinal number to a smaller ordinal number.

8. The device as claimed in any of claims 5 to 7,
wherein the means (22) for selecting is configured to determine, in the event that the information units selected from two pairs have the same ordinal number and are different from one another, a third information unit whose value is between the information units selected.

9. The device as claimed in claim 8,
wherein the third information unit is a mean value from the two information units selected.

10. The device as claimed in claim 1 or 2,
wherein at least one preceding block or subsequent block of decoded information units is present, and
wherein the predetermined criterion depends on the preceding or subsequent block.

11. The device as claimed in claim 10,
wherein the means (22) for selecting is configured to use a threshold value, on the basis of which the predetermined criterion is set, the threshold value used being an information unit of the preceding block or subsequent block with an ordinal number close to the ordinal number or preferably identical with the ordinal number of the information unit to be selected.

12. The device as claimed in any of the previous claims,
wherein the predetermined criterion is defined in that a change from an information unit to an information unit adjacent in the block or to an information unit of a preceding or subsequent block of information units of the same ordinal number is small.

13. The device as claimed in any of claims 1 to 12,
wherein the information unit by itself or in connection with a further quantity represents a property, and wherein the predetermined criterion is defined such that a change in property is small.

14. The device as claimed in claim 13,
wherein the property is an energy.

15. The device as claimed in claim in 14,
wherein the change in energy is defined in two successive blocks with regard to a change between two adjacent information units of the same block or two information units of the same ordinal number.

16. The device as claimed in any of claims 1 to 15,
wherein the information units are scale factors of an audio signal, the scale factors being differentially coded in addition to a coding using code words of variable length, so that a code word of variable length represents a differentially coded scale factor.

17. The device as claimed in claim 16,
wherein the predetermined criterion is defined such that a change in energy to a scale factor band adjacent in terms of frequency or to a scale factor band with the same ordinal number from a block which is preceding in time or successive in time is small.

18. The device as claimed in any of the previous claims,
wherein the block of reversible code words of variable lengths has a criterion indicator associated with it, the means (22) for selecting being configured to switch from a first to a second predetermined criterion depending on the criterion indicator.

19. The device as claimed in any of the previous claims,
wherein the predetermined criterion depends on a previously known property of an information signal determined by the information units.

20. The device as claimed in claim 19,
wherein the information signal is an audio signal and/or a video signal.

21. The device as claimed in claim 1 or 2,
wherein the means for selecting is configured to determine an overall property for an plurality of different paths in the error-concealment area, each path extending between different forward- and backward-decoding values, and the means for selecting being configured to select those decoding values which lie on the path that has an overall property which corresponds to the predetermined criterion.

22. The device as claimed in claim 21, wherein the means for selecting takes into account only a path which precisely exhibits a change from a forward-decoding value to a backward-decoding value or vice versa.

23. The device as claimed in any of claims 1 to 20,
wherein the means for selecting is configured to detect whether a change has already occurred in a selection in an error-concealment area with several pairs of forward-decoding values and backward-decoding values, and
wherein the means for selecting is configured to select, in the event of a change for information units following the change, regardless of the predetermined criterion, such decoding values which require no further change.

24. A method for concealing an error in an erroneous or potentially erroneous information unit, the method comprising:
forward-decoding (14) a block (12) of reversible code words of variable lengths which represent a block of information units, the block of code words having a starting point (SP) and an end point (EP), the means for forward-decoding (14) being configured to decode the block in the direction of the end point, starting from the starting point;
backward-decoding (16) the block of code words, starting from the end point, in the direction of the starting point;
determining (18) an error-concealment area, the error-concealment area being given by the means for forward-decoding (14) providing a decoded forward-decoding value for the information unit, and the means (16) for backward-decoding providing a decoded backward-decoding value for the information unit, the forward-decoding value and the backward-decoding value deviating from one another for one and the same information unit; and
selecting (22) the forward-decoding value or the backward-decoding value as an information unit, depending on which value meets a predetermined criterion, so that an error or a potential error in the information unit is concealed.

25. A computer program having a program code for performing the method of concealing an error in an erroneous or potentially erroneous information unit as claimed in claim 24 when the computer program runs on a computer.

## Revendications

1. Dispositif de masquage d'une erreur dans une unité d'information défectueuse ou potentiellement défectueuse, aux caractéristiques suivantes :
un dispositif (14) destiné au décodage direct d'un bloc (12) de mots de code réversibles de longueur variable représentant un bloc d'unités d'information, le bloc de mots de code ayant un point de début (SP) et un point de fin (EP), le dispositif destiné au décodage direct (14) étant réalisé de manière à décoder le bloc, en partant du point de début, en direction du point de fin ;
un dispositif (16) destiné au décodage inverse du bloc de mots de code, en partant du point de fin, en direction du point de début ;
un dispositif (18) destiné à déterminer une zone de masquage d'erreur, la zone de masquage d'erreur étant donnée par le fait que le dispositif destiné au décodage direct (14) fournit une valeur de décodage direct décodée pour l'unité d'information, et le dispositif (16) destiné au décodage inverse fournissant une valeur de décodage inverse pour l'unité d'information, la valeur de décodage direct et la valeur de décodage inverse pour la même unité d'information étant différentes l'une de l'autre ; et
un dispositif (22) destiné à sélectionner la valeur de décodage direct ou la valeur de décodage inverse comme unité d'information en fonction de la valeur qui remplit un critère prédéterminé, de sorte qu'une erreur ou une erreur potentielle dans l'unité d'information soit masquée.

2. Dispositif selon la revendication 1,
dans lequel le dispositif (22) destiné à sélectionner est réalisé dé manière à utiliser une valeur de seuil sur base de laquelle est réglé le critère prédéterminé.

3. Dispositif selon la revendication 2,
dans lequel le dispositif (22) destiné à sélectionner est réalisé de manière à utiliser comme valeur de seuil une unité d'information intacte adjacente à l'unité d'information ou une unité d'information reconstruite dans une étape précédente, et
le critère prédéterminé étant réglé de sorte que soit sélectionnée comme unité d'information la valeur qui est la plus proche de la valeur de seuil ou, alternativement, la plus éloignée de la valeur de seuil.

4. Dispositif selon l'une des revendications 1-3,
dans lequel la zone de masquage d'erreur présente une pluralité de valeurs de décodage direct et de valeurs de décodage inverse.

5. Dispositif selon l'une des revendications 1 à 4,
dans lequel le dispositif (22) destiné à sélectionner est réalisé de manière à sélectionner une valeur comme unité d'information tant pour une paire composée d'une valeur de décodage direct et d'une valeur de décodage inverse à faible nombre d'ordre dans la zone de masquage d'erreur que pour une paire composée d'une valeur de décodage direct et d'une valeur de décodage inverse à haut nombre d'ordre dans la zone de masquage d'erreur.

6. Dispositif selon la revendication 5,
dans lequel le dispositif (22) destiné à sélectionner est réalisé de manière à utiliser pour une sélection parmi la paire au faible nombre d'ordre une valeur de seuil sur base de l'unité d'information à nombre d'ordre inférieur de 1, et
de manière à utiliser pour une sélection parmi la paire au nombre d'ordre élevé une valeur de seuil sur base de l'unité d'information à nombre d'ordre supérieur de 1.

7. Dispositif selon la revendication 5 ou 6,
dans lequel le dispositif (22) destiné à sélectionner est réalisé de manière à sélectionner des unités d'information pas à pas du nombre d'ordre inférieur à un nombre d'ordre supérieur et du nombre d'ordre supérieur à nombre d'ordre inférieur.

8. Dispositif selon l'une des revendications 5 à 7,
dans lequel le dispositif (22) destiné à sélectionner est réalisé de manière à déterminer, au cas où les unités d'information sélectionnées parmi deux paires ont le même nombre d'ordre et sont différentes l'une de l'autre, une troisième unité d'information qui a une valeur qui se situe entre les unités d'information sélectionnées.

9. Dispositif selon la revendication 8,
dans lequel la troisième unité d'information est une valeur moyenne des deux unités d'information sélectionnées.

10. Dispositif selon la revendication 1 ou 2,
dans lequel est présent au moins un bloc précédent ou un bloc suivant d'unités d'information décodées, et
dans lequel le critère prédéterminé est fonction du bloc précédent ou du bloc suivant.

11. Dispositif selon la revendication 10,
dans lequel le dispositif (22) destiné à sélectionner est réalisé de manière à utiliser une valeur de seuil sur base de laquelle est réglé le critère prédéterminé, comme valeur de seuil étant utilisée une unité d'information du bloc précédent ou du bloc suivant à nombre d'ordre qui est proche du nombre d'ordre ou, de préférence, identique au nombre d'ordre de l'unité d'information à sélectionner.

12. Dispositif selon l'une des revendications précédentes,
dans lequel le critère prédéterminé est défini en ce sens qu'une variation d'une unité d'information à une unité d'information adjacente dans le bloc ou à une unité d'information d'un bloc d'unités d'information précédent ou suivant du même nombre d'ordre est faible.

13. Dispositif selon l'une des revendications 1 à 12,
dans lequel l'unité d'information représente, seule ou en connexion avec une autre grandeur, une propriété et le critère prédéterminé est défini de sorte qu'une variation de propriété soit faible.

14. Dispositif selon la revendication 13,
dans lequel la propriété est une énergie.

15. Dispositif selon la revendication 14,
dans lequel la variation d'énergie est définie, en ce qui concerne une variation entre deux unités d'information adjacentes du même bloc ou deux unités d'information du même nombre d'ordre dans deux blocs successifs.

16. Dispositif selon l'une des revendications 1 à 15,
dans lequel les unités d'information sont des facteurs d'échelle d'un signal audio, les facteurs d'échelle étant, outre un codage à l'aide de mots de code de longueur variable, soumis à un codage de différence, de sorte qu'un mot de code de longueur variable représente un facteur d'échelle soumis à codage de différence.

17. Dispositif selon la revendication 16,
dans lequel le critère prédéterminé est défini de sorte qu'une variation d'énergie par rapport à une bande de facteurs d'échelle adjacente en fréquence ou à une bande de facteurs d'échelle de même nombre d'ordre d'un bloc précédent dans le temps ou suivant dans le temps est faible.

18. Dispositif selon l'une des revendications précédentes,
dans lequel au bloc de mots de code réversibles de longueur variable est associé un indicateur de critère, le dispositif (22) destiné à sélectionner étant réalisé de manière à commuter, en fonction de l'indicateur de critère, d'un premier à un deuxième critère prédéterminé.

19. Dispositif selon l'une des revendications précédentes,
dans lequel le critère prédéterminé est fonction d'une propriété connue d'avance d'un signal d'information déterminé par les unités d'information.

20. Dispositif selon la revendication 19,
dans lequel le signal d'information est un signal audio et/ou un signal vidéo.

21. Dispositif selon la revendication 1 ou 2,
dans lequel le dispositif destiné à sélectionner est réalisé de manière à déterminer une propriété d'ensemble pour une pluralité de trajets différents dans la zone de masquage d'erreur, chaque trajet s'étendant entre des valeurs de décodage direct et inverse différentes, et le dispositif destiné à sélectionner étant réalisé de manière à sélectionner les valeurs de décodage qui se situent sur le trajet qui a une propriété d'ensemble correspondant au critère prédéterminé.

22. Dispositif selon la revendication 21, dans lequel il n'est tenu compte par le dispositif destiné à sélectionner que d'un seul trajet présentant précisément un changement d'une valeur de décodage direct à une valeur de décodage inverse.

23. Dispositif selon l'une des revendications 1 à 20,
dans lequel le dispositif destiné à sélectionner est réalisé de manière à détecter s'il s'est déjà produit, dans une zone de masquage d'erreur à plusieurs paires de valeurs de décodage direct et de valeurs de décodage inverse, un changement lors d'une sélection, et
dans lequel le dispositif destiné à sélectionner est réalisé de manière à sélectionner, dans le cas d'un changement, pour des unités d'information suivant le changement, quel que soit le critère, les valeurs de décodage qui ne requièrent pas d'autre changement.

24. Procédé de masquage d'une erreur dans une unité d'information défectueuse ou potentiellement défectueuse, aux étapes suivantes consistant à :
effectuer un décodage direct (14) d'un bloc (12) de mots de code réversibles de longueur variable représentant un bloc d'unités d'information, le bloc de mots de code ayant un point de début (SP) et un point de fin (EP), le dispositif destiné au décodage direct (14) étant réalisé de manière à décoder le bloc, en partant du point de début, dans la direction du point de fin ;
effectuer le décodage inverse (16) du bloc de mots de code, partant du point de fin, en direction du point de début ;
déterminer (18) une zone de masquage d'erreur, la zone de masquage d'erreur étant obtenue en ce que le dispositif destiné au décodage direct (14) fournit une valeur de décodage direct décodée pour l'unité d'information et que le dispositif (16) destiné au décodage inverse fournit une valeur de décodage inverse décodée pour l'unité d'information, la valeur de décodage direct et la valeur de décodage inverse pour une même unité d'information étant différentes l'une de l'autre ; et
sélectionner (22) la valeur de décodage direct ou la valeur de décodage inverse comme unité d'information en fonction de la valeur qui remplit un critère prédéterminé, de sorte qu'une erreur ou une erreur potentielle dans l'unité d'information soit masquée.

25. Programme d'ordinateur avec un code de programme pour la réalisation du procédé de masquage d'une erreur dans une unité d'information défectueuse ou potentiellement défectueuse selon la revendication 24 lorsque le programme d'ordinateur se déroule sur un ordinateur.
